# EUROPÄISCHE PATENTSCHRIFT

(11) **EP 2 091 105 B1**
(45) Veröffentlichungstag und Bekanntmachung des Hinweises auf die Patenterteilung: **17.10.2018**
(21) Anmeldenummer: 09150216.1
(22) Anmeldetag: 08.01.2009
(51) Int. Cl.: H01R 9/26

(54) **Anreihbares Elektronikgehäuse**
Directly mounted electronics housing
Boîtier électronique pouvant être joint

(30) Priorität: 14.02.2008 DE 202008002113 U
(43) Veröffentlichungstag der Anmeldung: 19.08.2009
(73) Patentinhaber: Weidmüller Interface GmbH & Co. KG, 32758 Detmold (DE)
(72) Erfinder: Heggemann, Christian, 32758 Detmold (DE); Oesterhaus, Jens, 32760 Detmold (DE); Bönsch, Matthias, 33659 Bielefeld (DE); Niggemann, Matthias, 32694 Dörentrup (DE); Lenschen, Michael, 32756 Detmold (DE); Fehling, Stephan, 32791 Lage (DE); Diekmann, Torsten, 33618 Leopoldshöhe (DE)
(74) Vertreter: Dantz, Jan Henning

(56) Entgegenhaltungen:
- EP-A2- 1 326 304
- DE-U1- 29 606 759
- DE-U1- 29 823 669

## Beschreibung

Die Erfindung betrifft ein anreihbares Elektronikgehäuse nach dem Oberbegriff des Anspruchs 1.

Derartige Elektronikgehäuse sind an sich bekannt, so aus der gattungsgemäßen EP 1 326 304, bedürfen aber einer weiteren konstruktiven Optimierung, insbesondere in Hinsicht auf die Montage und die Anpassbarkeit an unterschiedliche Anschlusstechniken und Baugrößen. Die Erfindung hat die Aufgabe, dieses Problem zu lösen.

Die Erfindung löst diese Aufgabe durch den Gegenstand des Anspruchs 1.

Damit ist es möglich, das Elektronikgehäuse auf einfache Weise an verschiedene Anschlusstechniken anzupassen. Es muss jeweils nicht das komplette Gehäuse neu ausgelegt werden, sondern es ist lediglich erforderlich, unterschiedliche Seitenteile zu schaffen.

Ferner ist es auf einfache Weise möglich, durch Variation der Seitenteile zwei oder mehr zueinander parallele Leiterplatten LP im Gehäuse anzuordnen bzw. mit vormontierten Seitenteilen einfach als Ganzes in einen Gehäusesockel zu setzen.

Zudem können beispielsweise durch Verändern der Seitenteile bzw. durch verschiedene Seitenteile Elektronikgehäuse mit mehr oder weniger großer Lüftungsfunktion oder Kühlfunktion realisiert werden.

Vorzugsweise sind an der wenigstens einen Leiterplatte Steckverbinder angeordnet und das Seitenteil oder die Seitenteile sind an den Steckverbindern verrastbar. Derart wird die Montage deutlich vereinfacht, da die Steckverbinder und die Seitenteile an der Leiterplatte LP vormontiert sind und dieses empfindliche Bauteil bei der Montage im Gehäusesockel gut geschützt ist. Derart bildet die wenigstens eine Leiterplatte mit den Steckverbinder und den Seitenteilen eine vormontierbare Einheit, die in den Gehäusesockel einsetzbar ist.

Besonders bevorzugt sind die Steckverbinder als Stiftleisten oder als Buchsenleisten ausgebildet. Andere Ausgestaltungen, so beispielsweise als RJ45-Stecker - oder - buchse - sind denkbar.

Vorteilhafte Ausgestaltungen der Erfindung sind den Unteransprüchen zu entnehmen.

Nachfolgend werden Ausführungsbeispiele der Erfindung unter Bezug auf die Figuren näher beschrieben. Es zeigt:
- Figur 1: eine perspektivische Ansicht eines Elektronikgehäuses;
- Figur 2: eine Schnittansicht durch das Elektronikgehäuse mit der Leiterplatte aus Figur 1;
- Figur 3: eine Seitenansicht des Elektronikgehäuses aus Figur 1;
- Figur 4: eine Draufsicht auf das Elektronikgehäuse der Figur 1;
- Figur 5: eine perspektivische Ansicht des Elektronikgehäuses mit einer Leiterplatte in teilweise explosionsartiger Darstellung;
- Figur 6: eine vergrößerte Ansicht eines Ausschnitts des Elektronikgehäuses aus Fig. 1; und
- Figur 7: einen Schnitt A-A durch den Ausschnitt aus Fig. 7.

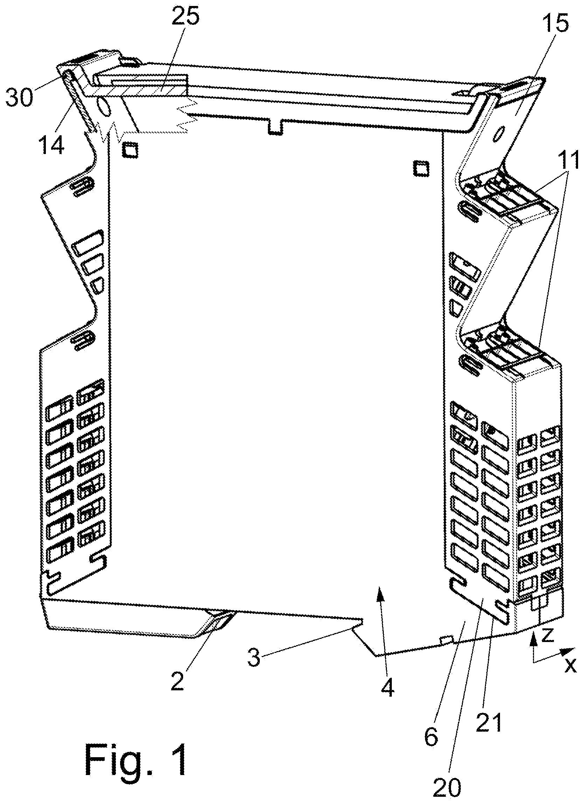

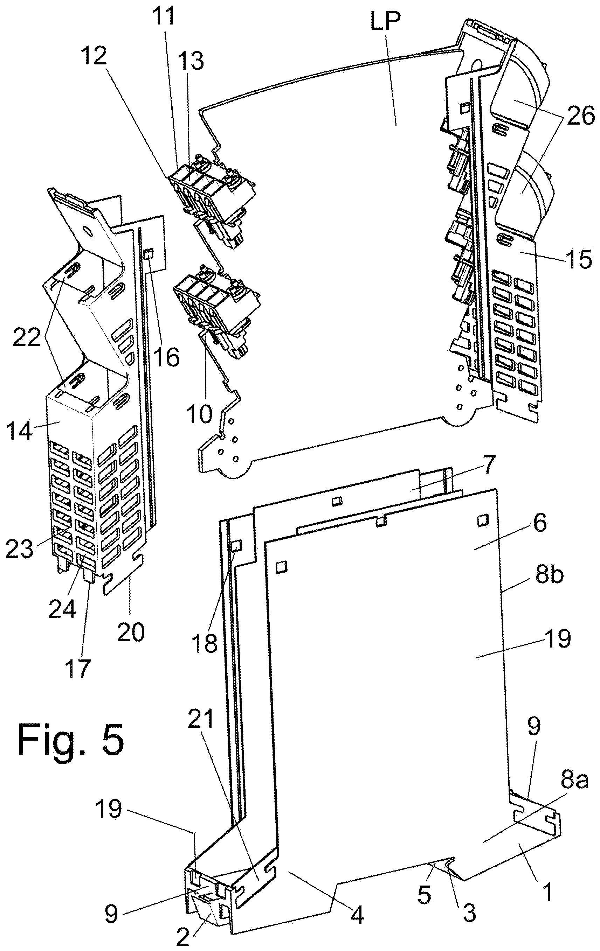

Figur 1 bzw. 5 zeigen eine perspektivische Ansicht eines mehrteiligen, anreihbaren Elektronikgehäuse 1, welches mit einem Rastfuß mit Rastmitteln 2, 3 zum Aufrasten auf eine hier nicht dargestellte, vorzugsweise U-förmige Tragschiene versehen ist. Die Aufrastbarkeit auf eine Tragschiene ist die bevorzugte - aber nicht zwingende - Auslegung. Es wäre auch denkbar, das Grundgehäuse 1 zum Auflegen auf eine andere Art von Montagebasis auszulegen, wozu die Rastfüße entsprechend zu modifizieren wären.

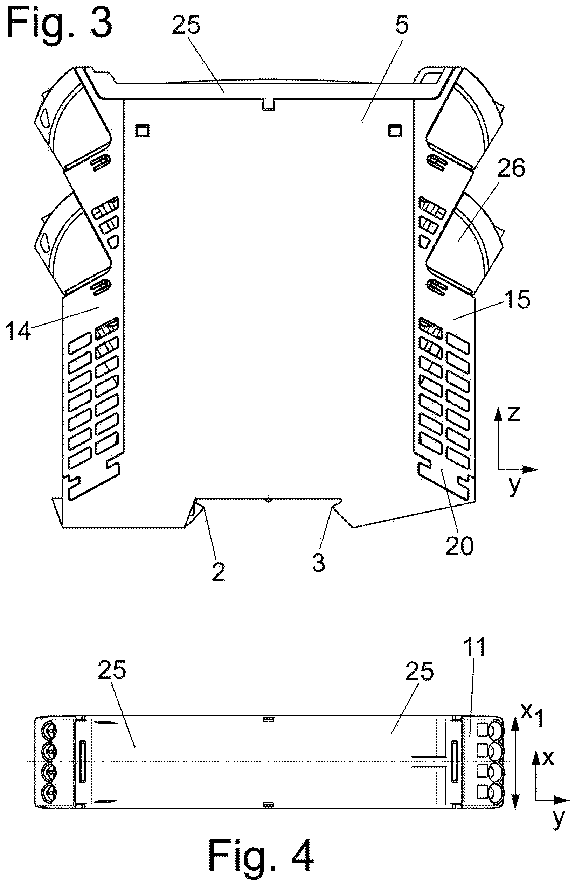

Die Elektronikgehäuse sind senkrecht zur Tragschienenrichtung X (Fig. 1), d.h. senkrecht zur Ebene der Figur 3 aneinander anreihbar.

Das Elektronikgehäuse 1 weist einen vorzugsweise einstückig als Spritzgussteil aus Kunststoff ausgebildeten Gehäusesockel 4 auf, der den Rastfuß mit den Rastmitteln 2, 3 aufweist, wobei das eine der Rastmittel eine Rastkante und das andere Rastmittel eine Art Schieber bzw. Betätigungsschieber sein kann.

Der Gehäusesockel 4 weist vorzugsweise ferner zur Tragschiene hin einen Bodenabschnitt 5 auf (hier nur im Bereich der Rastkante 3 zu erkennen), der geschlossen ausgebildet oder mit Öffnungen z.B. zur Realisierung von Lüftschlitzen oder Lüftkanälen versehen sein kann. Der Bodenbereich 5 erstreckt sich vorzugsweise beidseits der Tragschiene. Im Bereich des Rastfußes kann ein Mittel (hier nicht dargestellt) zur Kontaktierung einer Busleiste in der Tragschiene vorgesehen sein.

An den Bodenbereich 5 schließen sich senkrecht nach oben von der Tragschiene weg zwei Seitenwände 6, 7 an, die vorzugsweise parallel zueinander ausgerichtet sind und die im Abstand X₁ - dem Rastermaß des Elektronikgehäuses liegen. Diese Seitenwände werden nachfolgend als Hauptseitenwände 6, 7 (siehe Fig. 5) bezeichnet. Sie geben die Breite X₁ des Elektronikgehäuses 1 in Anreihrichtung X vor.

Die Hauptseitenwände 6, 7 erstrecken sich senkrecht zur Anreihrichtung X oberhalb der Tragschiene. Ihre Breite nimmt mit zunehmendem Abstand von der Tragschiene nach oben hin (Z-Richtung) ab. Sie weisen von der Tragschiene aus betrachtet in Z-Richtung zunächst einen in Y-Richtung zunächst breiteren Basisbereich 8a auf, der sich beidseits der Tragschiene erstreckt und in Z-Richtung oberhalb dieses Basisbereichs 8 einen schmaleren Bereich 8b, so dass die Hauptseitenwände 6, 7 - relativ zur Tragschiene - im Wesentlichen die Kontur eines umgedrehten T aufweisen.

Es ist möglich, dass der Gehäusesockel zumindest im Bereich des Basisbereiches 8a auch die Hauptseitenwände 6, 7 im Basisbereich 8a verbindende - relativ kurze - Seitenwandabschnitte 9 aufweist.

Im Grundgehäuse 1 wird zwischen den Seitenwänden 6, 7 ein Aufnahmeraum für wenigstens eine oder aber mehrere Leiterplatte(n) LP geschaffen, wie sie in Figur 1 im oberen Teil dargestellt ist.

Diese Leiterplatte LP weist vorzugsweise - jedenfalls abschnittsweise - nahezu sägezahnartige Seitenkonturen auf, wobei gestufte Abschnitte 10 (Fig. 5), welche am Leiterplattenrand ausgebildet sind, dazu genutzt werden, auf dem Rand der Leiterplatte LP wenigstens eine oder mehrere Stiftleiste(n) 11 (oder alternativ Buchsenleisten) anzuordnen, die mit der Leiterplatte über Kontaktbereiche (hier nicht im einzelnen zu erkennen) leitend, z. B. mittels einer Löttechnik, verbunden ist.

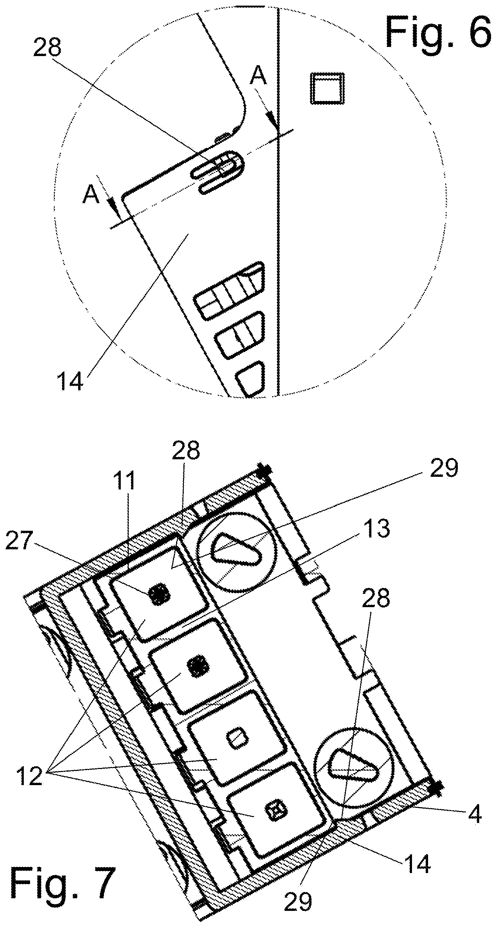

Die Stiftleiste 11 weist mehrere voneinander getrennte Anschlusskammern 12 auf, die durch Zwischenwände 13 voneinander getrennt sind und jeweils dazu ausgelegt sind, einen Anschlussstift 27 aufzunehmen (siehe Fig. 7).

Analog wäre es möglich, eine Buchsenleiste 26, wie sie in Figur 1 ebenfalls zu erkennen ist und die zum Aufrasten auf die Stiftleiste dient, an den Leiterplatten LP zu befestigen.

Die Stiftleisten 11 sitzen jeweils auf den gestuften Abschnitten 10 vorzugsweise derart, dass sie sich im wesentlichen senkrecht beidseits des Leiterplattenrandes erstrecken, wobei sie jeweils auf unteren Schenkeln der gestuften Abschnitte 10 aufliegen, derart, dass in sie im wesentlichen aus einer Richtung relativ zur Tragschiene "von oben nach unten" die korrespondierenden Buchsenleisten 26 einsteckbar sind.

Der Gehäusesockel 4 weist im Bereich oberhalb der Basis zwischen den Hauptseitenwänden 6, 7 keine mit ihm einstückig verbundenen Seitenteile auf, welche das Elektronikgehäuse 1 rundum abschließen.

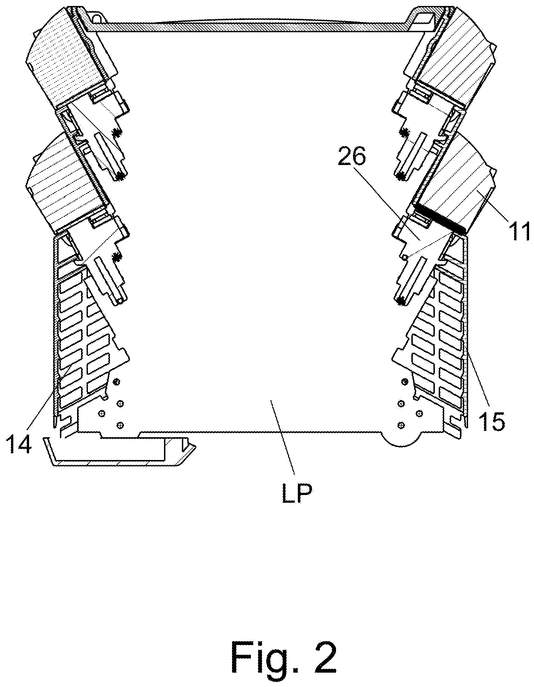

Bei dem Konzept der Figuren 1 bis 4 ist vielmehr vorgesehen, am Gehäusesockel 4 festlegbare Seitenteile 14, 15 zu realisieren, die an das Grundgehäuse 1 ansetzbar und dort vorzugsweise rastend festlegbar sind. Sie verbinden die Hauptseitenwände 6, 7 miteinander und sind senkrecht zu diesen ausgerichtet.

In der Draufsicht weisen diese Seitenteile 14, 15 im Wesentlichen eine U-förmige Kontur auf. Sie sind derart ausgestaltet, dass sie vorzugsweise insbesondere im Bereich ihrer Längsschenkel mit Rastmitteln 16, 17 an korrespondierenden Rastmitteln 18, 19 bzw. 20, 21 am Gehäusesockel 4 verrastbar sind.

Hier bilden die Rastmittel 20 und 21 korrespondierende Elemente eines Schlosses aus, das derart ausgestaltet ist, dass ein T-förmiger Ansatz 20 der Seitenteile 14, 15 in einer T-förmigen, in die die Hauptseitenwände 5, 6 von gegenüberliegenden Seiten eingeformte, diese aber vorzugsweise nicht durchsetzende Ausnehmung 21 in der Außenseite der Basis 8 der Hauptseitenwände 6, 7 schnappend verrastbar ist (Siehe Fig. 5). Insgesamt sind hier vier dieser Schlösser vorgesehen (je Hauptseitenwand zwei)

Die U-förmigen Seitenteile 14, 15 weisen in der Seitenansicht der Figur 3 eine ebenfalls abschnittsweise gestufte Kontur auf, die mit Aussparungen 22 versehen ist, die derart ausgebildet und angeordnet sind, dass in ihnen im zusammengebauten Zustand die Stiftleisten 11 zu liegen kommen, wobei es möglich ist, die Stiftleisten 11 mit den Buchsenleisten 26 durch die Aussparung 22 hindurch zu kontaktieren.

Vorzugsweise sind an der Innenseite der Seitenteile 14, 15 Abstützkonturen für die Stiftleisten vorgesehen, die derart ausgestaltet sind, dass Zug- und Druckkräfte, die beim Be- und Entschalten auf die Stiftleiste wirken, nicht an der empfindlichen Leiterplatte sondern über die Seitenteile 14, 15 am Elektronikgehäuse abgestützt werden (hier nicht dargestellt).

Zudem sind die Seitenteile 14 mit an den Innenseiten der Längsschenkel ausgebildeten Rastmitteln, hier Rastvorsprüngen 28, in Rastausnehmungen oder hinter Kanten 29 der Stiftleisten 11 an der Leiterplatte LP verrastbar (Fig. 7).

Derart können die Seitenteile 14, 15 an der Leiterplatte vormontiert werden. Diese vormontierte Einheit kann dann als Ganzes in den Gehäusesockel 4 eingesetzt und dort verrastet werden, wobei die Seitenteile mit Ansätzen 20 in die Konturen 21 schnappen.

Ein Gehäusesockel 23 unterhalb der sägezahnartigen Kontur kann dazu vorgesehen sein, Luftschlitze oder anders gestaltete Öffnungen zur Realisierung einer Lüftungsfunktion auszubilden.

Vorzugsweise bestehen sämtliche Teile des Elektronikgehäuses, also insbesondere das Grundgehäuse und die Seitenteile 14, 15 aus isolierendem Kunststoff.

Denkbar ist es aber auch, die Seitenteile 14, 15 aus Metall zu fertigen und/oder die Komponenten des Elektronikgehäuses aus unterschiedlichen Materialien wie z.B. Kunststoff oder Metall zu fertigen.
Es ist auch möglich, neben den Kühlöffnungen 24 eine Art Kühlrippe 24 an den Seitenteilen 14, 15 vorzusehen, die sich beispielsweise parallel zur Leiterplatte erstreckt und aus dem Gehäuse herausführt und dazu dient, Wärme abzuleiten.
In X-Richtung beträgt die Erstreckung des Elektronikgehäuses 1 der Fig. 1 z.B. 12,5 mm.
Nach oben abgeschlossen wird das Elektronikgehäuse 1 von einem Deckelteil 25, das vorzugsweise an den Seitenteilen 14, 15 und an den Hauptseitenwänden 5, 6 rastend festlegbar ist. Nach Fig.1 erfolgt diese Verrastung 30 nach Art einer Klammer, welche die Seitenteile 14, 15 außen (in Y-Richtung) hintergreift, so dass das Deckelteil 25 ein Auseinanderziehen der Seitenteile 14, 15 senkrecht zur Tragschiene (in Y-Richtung) verhindert. Der Deckel 25 kann auch weitere Anschlüsse aufnehmen und/oder für Markierzwecke genutzt werden.
Bevorzugt erstreckt sich das Gehäuse in Tragschienenrichtung über 12,5 mm oder mehr.
Dabei ist es denkbar, die Elektronikgehäuse 1 derart auszugestalten, dass sie jeweils zwei oder mehr Leiterplatten LP aufnehmen (hier nicht dargestellt).
Während die Seitenteile 14, 15 hier derart ausgelegt sind, dass an ihnen Stiftleisten kontaktierbar sind, können die Aussparungen 22 auch derart gestaltet werden, dass andere Anschlüsse durch sie erreichbar sind, so beispielsweise Stecker im RJ45-Format, lichtleitende Stecker oder aber Stecker oder Buchsen anderer Art.
Durch die Sägezahnform ist es möglich, in Richtung senkrecht zur Tragschiene relativ hoch zu bauen, was vorteilhaft ist, da in dieser Richtung der Bauraum meist eher weniger beschränkt ist.

### Bezugszeichen

- Grundgehäuse: 1
- Rastmittel: 2, 3
- Gehäusesockel: 4
- Bodenabschnitt: 5
- Seitenwand: 6, 7
- Basisbereich: 8
- Seitenwandabschnitt: 9
- Leiterplatte: 9
- Abschnitt: 10
- Stiftleiste: 11
- Anschlusskammer: 12
- Zwischenwand: 13
- Seitenteil: 14, 15
- Rastmittel: 16, 17
- Bereich: 19
- Rastmittel: 18, 19, 20, 21
- Ansatz: 20
- Aussparung: 22
- Gehäusesockel: 23
- Kühlöffnung: 24
- Deckelteil: 25
- Buchsenleiste: 26
- Anschlussstift: 27
- Rastvorsprünge: 28
- Kanten: 29
- Verrastung: 30
- Leiterplatte: LP

## Patentansprüche

1. Mehrteiliges anreihbares Elektronikgehäuse (1) zur Aufnahme wenigstens einer Leiterplatten (LP) oder mehrerer Leiterplatten (LP),
a. mit einem Rastfuß mit Rastmitteln (2, 3) zum Aufrasten auf eine Montagebasis wie eine Tragschiene,
b. mit einem vorzugsweise einstückig ausgebildeten Gehäusesockel (4), der den Rastfuß aufweist sowie vorzugsweise einen Bodenabschnitt (5) und zwei zueinander parallele Hauptseitenwände (5, 6), die das Elektronikgehäuse jeweils in Anreihrichtung begrenzen,
c. sowie mit separat zum Gehäusesockel (4) ausgebildeten, an den Gehäusesockel (4) anrastbaren Seitenteilen (14, 15), welche(s) die Hauptseitenwände (6, 7) miteinander verbinden,
d. wobei an der wenigstens einen Leiterplatte (LP) Steckverbinder (11) angeordnet sind, und
**dadurch gekennzeichnet, dass**
e. die Seitenteile (14) über ein Deckelteil (25) miteinander verbunden und klammerartig gegen ein Auseinanderziehen senkrecht zur Tragschiene gesichert sind.

2. Elektronikgehäuse nach Anspruch 1, **dadurch gekennzeichnet, dass** die Seitenteile (14,15) an den Steckverbindern (11) verrastbar sind.

3. Elektronikgehäuse nach Anspruch 2, **dadurch gekennzeichnet, dass** die Leiterplatten (LP) mit den Steckverbinder und den Seitenteilen (14, 15) eine vormontierbare Einheit bilden, die in den Gehäusesockel (4) einsetzbar ist.

4. Elektronikgehäuse nach Anspruch 3, **dadurch gekennzeichnet, dass** die Steckverbinder als Stiftleisten (11) oder als Buchsenleisten (12) ausgebildet sind.

5. Elektronikgehäuse nach einem der vorstehenden Ansprüche, **dadurch gekennzeichnet, dass** die Hauptseitenwände (6, 7) von der Tragschiene aus betrachtet betrachtet senkrecht zur Tragschiene nach oben - in Z-Richtung - zunächst einen senkrecht zur Anreihrichtung der Elektronikgehäuse - Y-Richtung - zunächst breiteren Basisbereich (8a) aufweisen, der sich beidseits der Tragschiene erstreckt und in Z-Richtung oberhalb dieses Basisbereichs (8) einen schmaleren Bereich (8b), so dass die Hauptseitenwände (6, 7) - relativ zur Tragschiene - im Wesentlichen die Kontur eines umgedrehten T aufweisen.

6. Elektronikgehäuse nach einem der vorstehenden Ansprüche, **dadurch gekennzeichnet, dass** der Gehäusesockel (4) nur im Bereich des Basisbereiches (8a) die Hauptseitenwände (6, 7) im Basisbereich (8a) verbindende Seitenwandabschnitte (9) aufweist.

7. Elektronikgehäuse nach einem der vorstehenden Ansprüche, **dadurch gekennzeichnet, dass** die Leiterplatte(n) jeweils jedenfalls abschnittsweise eine sägezahnartige Seitenkontur aufweisen, wobei gestufte Abschnitte (10) gebildet werden, auf denen die Steckverbinder (11) angeordnet sind, wobei sich die Steckverbinder in Anreihrichtung (X) erstrecken..

8. Elektronikgehäuse nach einem der vorstehenden Ansprüche, **dadurch gekennzeichnet, dass** die Seitenteile (14, 15) in einer Draufsicht eine U-förmige Form aufweisen.

9. Elektronikgehäuse nach einem der vorstehenden Ansprüche, **dadurch gekennzeichnet, dass** die Seitenteile (14, 15) mit Rastmitteln, die korrespondierende Elemente eines Schlosses ausbilden, am Gehäusesockel (4) verrastbar sind.

10. Elektronikgehäuse nach einem der vorstehenden Ansprüche, **dadurch gekennzeichnet, dass** an der Innenseite der Seitenteile (14, 15) Abstützkonturen für die Steckverbinder, insbesondere Stiftleisten, vorgesehen sind, die derart ausgestaltet sind, dass Zug- und Druckkräfte, die beim Be- und Entschalten auf die Steckverbinder, insbesondere die Stiftleiste, wirken, am Elektronikgehäuse (1) abgestützt werden.

11. Elektronikgehäuse nach einem der vorstehenden Ansprüche, **dadurch gekennzeichnet, dass** die Seitenteile (14, 15) Luftschlitze oder anders gestaltete Öffnungen zur Realisierung einer Lüftungsfunktion aufweisen.

12. Elektronikgehäuse nach einem der vorstehenden Ansprüche, **dadurch gekennzeichnet, dass** an einem oder beiden der Seitenteile (14, 15) Kühlkörper für die Leiterplatte (LP) vorgesehen sind.

## Claims

1. Multipart serially alignable electronic housing (1) to receive at least one printed circuit board (LP) or several printed circuit boards (LP),
a. with a latch foot with latch means (2, 3) for latching upon an assembly base, such as a mounting rail,
b. with a preferably individual housing base (4), that has the latch foot, as well as, preferably, a bottom segment (5), and two mutually parallel main side walls (5, 6), that limit the electronic housing in each case in the direction of alignment,
c. as well as with side parts (14, 15) that can be latched upon the housing base (4) and that are made separately with respect to the housing base (4), and that connect the main side walls (6, 7) with each other,
d. wherein there are arranged patch plugs (11) on the at least one printed circuit board (LP), and
**characterized in that**
e. the side parts (14) are connected with each other via a lid part (25) and are secured against being pulled apart perpendicularly to the mounting rail in the manner of a clamp.

2. Electronic housing according to Claim 1, **characterized in that** the side parts (14, 15) can be locked upon the patch plugs (11).

3. Electronic housing according to Claim 2, **characterized in that** the printed circuit boards (LP), with the patch plugs and the side parts (14, 15) constitute a pre-assembleable unit that can be inserted into the housing base (4).

4. Electronic housing according to Claim 3, **characterized in that** the patch plugs are made as pins strips (11) or as socket strips (12).

5. Electronic housing according to one of the above claims, **characterized in that** the main side walls (6, 7), viewed from the mounting rail, perpendicularly upwards with respect to the mounting rail - in the Z direction - first of all have a base area (8a) that initially is wider perpendicularly in the alignment direction of the electronics housings - the Y direction - and that extends on both sides of the mounting rail and, in the Z direction, above that base area (8), have a narrower area (8b) so that the main side walls (6, 7) - with relation to the mounting rail - essentially have the contour of a reverse T.

6. Electronic housing according one of the above claims, **characterized in that** the housing base (4), only in the area of the base area (8a) has side wall segments (9) that connect the main side walls (6, 7) in the base area (8a).

7. Electronic housing according to one of the above claims, **characterized in that** the printed circuit board or boards in each case also have, segmentally, a sawtooth-like side contour, whereby graduated segments (10) are made, upon which are arranged the patch plugs (11), whereby patch plugs extend in the direction of alignment (X).

8. Electronic housing according to one of the above claims, **characterized in that** the side parts (14, 15), in a top view, display a U-shaped form.

9. Electronic housing according to one of the above claims, **characterized in that** the side parts (14, 15), can be locked upon housing base (4) by means of latch means that constitute the corresponding elements of a lock.

10. Electronic housing according to one of the above claims, **characterized in that**, on the inside of the side parts (14, 15), there are provided support contours for the patch plugs, in particular, pin strips, that are designed in such a way that correction and pressure forces, which, during connection and disconnection, act on the patch plugs, especially on the pin strip, are supported upon the electronic housing (1).

11. Electronic housing according to one of the above claims, **characterized in that** the side parts (14, 15) display air slits or differently shaped openings to put in a ventilation function.

12. Electronic housing according to one of the above claims, **characterized in that** cooling bodies for the printed circuit board (LP) are provided on one or both of the side parts (14, 15).

## Revendications

1. Boîtier électronique juxtaposable en plusieurs parties (1) destiné à recevoir au moins une carte de circuit imprimé (LP) ou plusieurs cartes de circuit imprimé (LP),
a. comportant un pied d'encliquetage avec des moyens d'encliquetage (2, 3) destinés à s'encliqueter sur une base de montage telle qu'un rail de support,
b. comportant un socle de boîtier (4), de préférence réalisé d'une seule pièce, qui présente le pied d'encliquetage ainsi que de préférence une partie fond (5) et deux parois latérales principales (5, 6) qui sont parallèles l'une à l'autre et qui délimitent chacune le boîtier électronique dans la direction de juxtaposition,
c. et comportant des parties latérales (14, 15) formées séparément du socle de boîtier (4), qui peuvent être encliquetées sur le socle de boîtier (4) et qui relient les parois latérales principales (6, 7) l'une à l'autre,
d. des connecteurs (11) étant disposés sur ladite au moins une carte de circuit imprimé (LP), et
**caractérisé en ce que**
e. les parties latérales (14) sont reliées entre elles par une partie couvercle (25) et sont assurées par serrage contre une séparation par traction perpendiculaire au rail de support.

2. Boîtier électronique selon la revendication 1, **caractérisé en ce que** les parties latérales (14, 15) peuvent être verrouillées sur les connecteurs (11).

3. Boîtier électronique selon la revendication 2, **caractérisé en ce que** les cartes de circuits imprimés (LP) forment avec les connecteurs et les parties latérales (14, 15) une unité prémontable qui peut être insérée dans le socle de boîtier (4).

4. Boîtier électronique selon la revendication 3, **caractérisé en ce que** les connecteurs sont réalisés sous la forme de barrettes à broches (11) ou de barrettes à douilles (12).

5. Boîtier électronique selon l'une des revendications précédentes, **caractérisé en ce que** les parois latérales principales (6, 7), vues depuis le rail de support, présentent perpendiculairement au rail de montage vers le haut - dans une direction Z - d'abord une zone de base (8a) initialement plus large perpendiculairement à la direction de juxtaposition des boîtiers électroniques - direction Y - qui s'étend des deux côtés du rail de support et, dans la direction Z, au-dessus de cette zone de base (8), une zone plus étroite (8b), de sorte que les parois latérales principales (6, 7) présentent - par rapport au rail de support - sensiblement le contour d'un T inversé.

6. Boîtier électronique selon l'une des revendications précédentes, **caractérisé en ce que** le socle de boîtier (4) présente des parties de paroi latérale (9) reliant les parois latérales principales (6, 7) uniquement au niveau de la zone de base (8a).

7. Boîtier électronique selon l'une des revendications précédentes, **caractérisé en ce que** la ou les carte(s) de circuit imprimé présente(nt) chacune, en tous cas sur certaines parties, un contour latéral en dents de scie, des parties étagées (10) étant formées, sur lesquelles sont disposés les connecteurs (11), lesquels connecteurs s'étendent dans la direction de juxtaposition (X).

8. Boîtier électronique selon l'une des revendications précédentes, **caractérisé en ce que** les parties latérales (14, 15) présentent une forme en U dans une vue de dessus.

9. Boîtier électronique selon l'une des revendications précédentes, **caractérisé en ce que** les parties latérales (14, 15) peuvent être verrouillées sur le socle de boîtier (4) avec des moyens d'encliquetage qui forment des éléments correspondants d'une serrure.

10. Boîtier électronique selon l'une des revendications précédentes, **caractérisé en ce que** des contours d'appui pour les connecteurs, en particulier des barrettes à broches, sont prévus sur le côté intérieur des parties latérales (14, 15), lesquels sont conçus de telle sorte que les forces de traction et de compression qui agissent sur les connecteurs, en particulier les barrettes à broches, lors de la connexion et de la déconnexion, sont supportées par le boîtier électronique (1).

11. Boîtier électronique selon l'une des revendications précédentes, **caractérisé en ce que** les parties latérales (14, 15) présentent des fentes d'aération ou des ouvertures de forme différente pour réaliser une fonction de ventilation.

12. Boîtier électronique selon l'une des revendications précédentes, **caractérisé en ce que** des dissipateurs de chaleur pour la carte de circuit imprimé (LP) sont prévus sur l'une des parties latérales (14, 15) ou sur les deux.
